# EUROPEAN PATENT SPECIFICATION

(11) **EP 2 934 883 B1**
(45) Date of publication and mention of the grant of the patent: **27.06.2018**
(21) Application number: 13818146.6
(22) Date of filing: 19.12.2013
(51) Int. Cl.: C08F 222/02, C09D 123/08, H01L 51/44, B32B 17/10, A63B 37/00, C08J 5/18

(54) **CROSS-LINKED POLYMERS AND THEIR USE IN PACKAGING FILMS AND INJECTION MOLDED ARTICLES**
VERNETZTE POLYMERE UND IHRE VERWENDUNG IN VERPACKUNGSFILMEN UND SPRITZGEGOSSENEN ARTIKELN
POLYMÈRE RÉTICULÉS ET LEUR UTILISATION DANS DES FILM D'EMBALLAGE ET DES ARTICLES MOULÉS PAR INJECTION

(30) Priority: 19.12.2012 US 201261739572 P; 19.12.2012 US 201261739557 P; 19.12.2012 US 201261739562 P
(43) Date of publication of application: 28.10.2015
(73) Proprietor: E. I. du Pont de Nemours and Company, Wilmington, DE 19898 (US)
(72) Inventor: PESEK, Steven, C., Orange, Texas 77632 (US); SMITH, Charles, Anthony, Vienna, West Virginia 26105 (US)
(74) Representative: Dannenberger, Oliver Andre
(86) International application number: PCT/US2013/076339
(87) International publication number: WO 2014/100313

(56) References cited:
- WO-A2-95/20625
- US-A- 3 361 702
- US-A- 4 906 703
- US-A- 5 395 895
- US-A- 5 576 396
- US-A1- 2005 255 328
- US-A1- 2005 256 268
- US-A1- 2007 049 673

## Description

### FIELD OF THE INVENTION

The present invention is directed to novel cross-linked polymers and their use in various materials, including packaging films and injection molded articles. The herein-described polymers, which comprise certain hydroxyl-containing crosslinking compounds, as well as optionally adjuvants, show improved creep resistance and exceptional stretch when compared to conventional ethylene acrylic or methacrylic acid copolymers or ionomers thereof.

### BACKGROUND OF THE INVENTION

Several patents, patent applications and publications are cited in this description in order to more fully describe the state of the art to which this invention pertains.

The use of polymers for packaging films, injection molded articles, and other end-uses is well known in the art. Some films are designed to be breathable, allow oxygen and/or moisture to pass through, exhibit elastic properties, and protect the materials they surround. See, for example, US 7,438,940, US 7,635,509, US2006/0094824, and US2010/0272898.

Polymeric materials can also be used for blown films (see, for example, US2011/0028622) and for thermoforming (see, for example, US2009/0099313 and US 8,110,138).There is a need for polymer materials for packaging end-uses that exhibit exceptional elongation while maintaining mechanical integrity. Moreover, there is a need for injection-molded articles that have the exceptional clarity associated with ethylene acid copolymers and ionomers combined with the improved mechanical properties provided by cross-linking. Crosslinking occurs when chemical bonds are formed between polymeric moieties that are present. Crosslinking allows the formation of polymeric networks that can enhance the overall strength of the material made from the composition, and allow improved elongation, mechanical integrity, and resistance to break.

Crosslinking by various methods is known. For example, ethylene vinyl acetate (EVA) is often crosslinked with peroxides to form sheets and encapsulants. However, unlike the crosslinking accomplished by the present invention, the crosslinking of EVA with peroxide can form gel and can lead to the degradation of the EVA. See, for example, U.S. Pat. No. 6,093,757, issued July 25, 2000 to Pern.

It has been found, and is shown in the examples included herein, that adding a hydroxyl-containing crosslinking agent to the ionomers in the melt can act to cross-link the ionomer, thus making the material more creep-resistant. While not wishing to be bound by theory, it is believed that the hydroxyl-containing crosslinking agent reacts with the carboxylate groups of the ionomers to form esters, which then cross-link the ionomers. As shown in the examples and figures included herein, the cross-linked ionomers exhibit good tensile strength as well. Additionally, the materials exhibit greater elongation with integrity when compared to sheets or films without the hydroxyl-containing crosslinking agent addition. The term "elongation with integrity", as used herein, refers to the ability of a film to stretch by 10% or greater without incurring any defects that would impair performance. Non-limiting examples of such defects include breaking, stretching and necking down to a thin fiber-like construction, and material unable to support its own weight.

### SUMMARY OF THE INVENTION

Provided herein is a polymer composition comprising an ethylene copolymer, said ethylene copolymer comprising copolymerized units of ethylene, about 5 to about 90 wt% of copolymerized units of a first α,β-unsaturated carboxylic acid having 3 to 10 carbon atoms; and optionally about 2 to about 40 wt% of copolymerized units of a derivative of a second α,β-unsaturated carboxylic acid having 3 to 10 carbon atoms. These weight percentages of the copolymerized units are based on the total weight of the ethylene copolymer. Optionally, at least a portion of the carboxylic acid groups of the copolymerized units of the α,β-unsaturated carboxylic acid units are neutralized to form carboxylate salts. The acid copolymer composition also includes a hydroxyl-containing crosslinking agent, and may optionally include an adjuvant.

Further provided herein is a product of cross-linking the acid copolymer composition described herein, wherein at least two of the carboxylic acid groups of the ethylene copolymer are reacted with two or more of the hydroxyl groups of the hydroxyl-containing crosslinking agent, to form cross-links between two or more ethylene copolymers.

Further provided are packaging films, and injection-molded articles comprising the polymer compositions described herein.

### BRIEF DESCRIPTION OF THE FIGURES/DRAWINGS

FIGURE 1 is a graphical representation of the tensile elongation of a polymer composition of the invention compared to that of a control material.
FIGURE 2 is a graphical representation of the laminate creep resistance of several polymer compositions of the invention compared to that of a control material.
FIGURE 3 is a graphical representation of the viscosity shear rate of a polymer composition of the invention compared to that of a control material.

### DETAILS OF THE INVENTION

The following definitions apply to the terms as used throughout this specification, unless otherwise limited in specific instances.

Moreover, unless otherwise defined, all technical and scientific terms used herein have the same meaning as commonly understood by one of ordinary skill in the art to which this invention belongs. In case of conflict, the present specification, including the definitions herein, will control.

As used herein, the term "copolymer" refers to polymers comprising copolymerized units or residues resulting from copolymerization of two or more comonomers. In this connection, a copolymer may be described herein with reference to its constituent comonomers or to the amounts of its constituent comonomers, for example "a copolymer comprising ethylene and 9 weight % of acrylic acid", or a similar description. Such a description may be considered informal in that it does not refer to the comonomers as copolymerized units; in that it does not include a conventional nomenclature for the copolymer, for example International Union of Pure and Applied Chemistry (IUPAC) nomenclature; in that it does not use product-by-process terminology; or for another reason. As used herein, however, a description of a copolymer with reference to its constituent comonomers or to the amounts of its constituent comonomers means that the copolymer contains copolymerized units (in the specified amounts when specified) of the specified comonomers. It follows as a corollary that a copolymer is not the product of a reaction mixture containing given comonomers in given amounts, unless expressly stated in limited circumstances to be such.

The term "acid copolymer" refers to a polymer comprising copolymerized units of an α-olefin, an α,β-ethylenically unsaturated carboxylic acid, and optionally other suitable comonomer(s), such as an α,β-ethylenically unsaturated carboxylic acid ester.

The term "(meth)acrylic", as used herein alone or in combined form, such as "(meth)acrylate", refers to acrylic or methacrylic, for example, "acrylic acid or methacrylic acid", or "alkyl acrylate or alkyl methacrylate".

The term "ionomer" refers to a polymer that is produced by partially or fully neutralizing an acid copolymer as described above. More specifically, the ionomer comprises ionic groups that are metal ion carboxylates, for example, alkali metal carboxylates, alkaline earth metal carboxylates, transition metal carboxylates and mixtures of such carboxylates. Such polymers are generally produced by partially or fully neutralizing the carboxylic acid groups of precursor or parent polymers that are acid copolymers, as defined herein, for example by reaction with a base. An example of an alkali metal ionomer as used herein is a sodium ionomer (or sodium neutralized ionomer), for example a copolymer of ethylene and methacrylic acid wherein all or a portion of the carboxylic acid groups of the copolymerized methacrylic acid units are in the form of sodium carboxylates.

The term "laminate", as used herein alone or in combined form, such as "laminated" or "lamination" for example, refers to a structure having at least two layers that are adhered or bonded firmly to each other. The layers may be adhered to each other directly or indirectly. "Directly" means that there is no additional material, such as an interlayer or an adhesive layer, between the two layers, and "indirectly" means that there is additional material between the two layers. Layers or films can be "laminated" together by heat and pressure, or can be co-extruded so that the layers adhere to each other.

The materials, methods, and examples herein are illustrative only and, except as specifically stated, are not intended to be limiting.

Finally, all percentages, parts, ratios, and the like set forth herein are by weight, unless otherwise stated in specific instances.

Provided herein is a polymer composition comprising an ethylene copolymer, which in turn comprises copolymerized units of ethylene, about 5 to about 90 wt% of copolymerized units, preferably about 5 to about 30 wt% of copolymerized units, of a first α,β-unsaturated carboxylic acid having 3 to 10, preferably 3 to 8, carbon atoms; and optionally about 2 to about 40 wt% or preferably from about 5 to 30 wt%, of copolymerized units of a derivative of a second α,β-unsaturated carboxylic acid having 3 to 10, preferably 3 to 8, carbon atoms. The weight percentages of the copolymerized units are based on the total weight of the ethylene copolymer, and the sum of the weight percentages of the copolymerized units is 100 wt%. Optionally at least a portion of the carboxylic acid groups of the copolymerized units of the α,β-unsaturated carboxylic acid units are neutralized to form carboxylate salts. The polymer composition further comprises a hydroxyl-containing crosslinking agent; and, optionally, also comprises an adjuvant.

Suitable α-olefin comonomers may include, but are not limited to, ethylene, propylene, 1-butene, 1-pentene, 1-hexene, 1-heptene, 3 methyl-1-butene, 4-methyl-1-pentene, and the like and mixtures of two or more thereof. In one preferred copolymer, the α-olefin is ethylene.

Suitable first α,β-ethylenically unsaturated acid comonomers may include, but are not limited to, carboxylic acids, including acrylic acids, methacrylic acids, itaconic acids, maleic acids, fumaric acids, and mixtures of two or more thereof. In one preferred copolymer, the α,β-ethylenically unsaturated carboxylic acid is selected from acrylic acids, methacrylic acids, and mixtures of two or more thereof. In another preferred copolymer, the α,β-ethylenically unsaturated carboxylic acid is methacrylic acid.

The ethylene copolymers may further comprise copolymerized units of one or more other comonomer(s), such as a second α,β-ethylenically unsaturated carboxylic acid having 2 to 10, or preferably 3 to 8 carbons, or derivatives thereof. Suitable acid derivatives include acid anhydrides, amides, and esters. Esters are preferred. Specific examples of preferred esters of unsaturated carboxylic acids include, but are not limited to, methyl acrylates, methyl methacrylates, ethyl acrylates, ethyl methacrylates, propyl acrylates, propyl methacrylates, isopropyl acrylates, isopropyl methacrylates, butyl acrylates, butyl methacrylates, isobutyl acrylates, isobutyl methacrylates, tert-butyl acrylates, tert-butyl methacrylates, octyl acrylates, octyl methacrylates, undecyl acrylates, undecyl methacrylates, octadecyl acrylates, octadecyl methacrylates, dodecyl acrylates, dodecyl methacrylates, 2-ethylhexyl acrylates, 2-ethylhexyl methacrylates, isobornyl acrylates, isobornyl methacrylates, lauryl acrylates, lauryl methacrylates, 2-hydroxyethyl acrylates, 2-hydroxyethyl methacrylates, glycidyl acrylates, glycidyl methacrylates, poly(ethylene glycol) acrylates, poly(ethylene glycol)methacrylates, poly(ethylene glycol) methyl ether acrylates, poly(ethylene glycol) methyl ether methacrylates, poly(ethylene glycol) behenyl ether acrylates, poly(ethylene glycol) behenyl ether methacrylates, poly(ethylene glycol) 4-nonylphenyl ether acrylates, poly(ethylene glycol) 4-nonylphenyl ether methacrylates, poly(ethylene glycol) phenyl ether acrylates, poly(ethylene glycol) phenyl ether methacrylates, dimethyl maleates, diethyl maleates, dibutyl maleates, dimethyl fumarates, diethyl fumarates, dibutyl fumarates, dimethyl fumarates, vinyl acetates, vinyl propionates, and mixtures of two or more thereof. In one preferred copolymer, the suitable additional comonomers are selected from methyl acrylates, methyl methacrylates, butyl acrylates, butyl methacrylates, glycidyl methacrylates, vinyl acetates, and mixtures of two or more thereof. In one preferred ethylene compolymer, the first α,β-ethylenically unsaturated carboxylic acid is the same as the second α,β-ethylenically unsaturated carboxylic acid; in another preferred ethylene copolymer, however, the first and the second α,β-ethylenically unsaturated carboxylic acids are different. In another preferred copolymer, however, the precursor acid copolymer does not incorporate other additional comonomers.

Suitable precursor acid copolymers have a melt flow rate (MFR) of about 1 to about 4000 g/10 min, or about 1 to 1000 g/10 min, or about 20 to about 400 g/10 min, as determined in accordance with ASTM method D1238-89 at 190°C and 2.16 kg.

Finally, suitable precursor acid copolymers may be synthesized as described in U.S. Patent Nos. 3,404,134; 5,028,674; 6,500,888; 6,518,365, or 8,399,096, for example. Some of these methods are also described in detail in U. S. Pat. No. 8,334,033, issued to Hausmann, et al.

To obtain the ionomers, the precursor acid copolymers are partially neutralized by reaction with one or more bases. An example of a suitable procedure for neutralizing the precursor acid copolymers is described in U.S. Patent Nos. 3,404,134 and 6,518,365. After neutralization, about 1% to about 90%, or about 10% to about 60%, or about 20% to about 55%, of the hydrogen atoms of carboxylic acid groups present in the precursor acid are replaced by other cations. Stated alternatively, about 1% to about 90%, or about 10% to about 60%, or about 20% to about 55%, of the total content of the carboxylic acid groups present in the precursor acid copolymer are neutralized. In another alternative expression, the acid groups are neutralized to a level of about 1% to about 90%, or about 10% to about 60%, or about 20% to about 55%, based on the total content of carboxylic acid groups present in the precursor acid copolymers as calculated or measured for the non-neutralized precursor acid copolymers. The neutralization level can be tailored for the specific end-use.

The ionomers comprise cations as counterions to the carboxylate anions. Suitable cations include any positively charged species that is stable under the conditions in which the ionomer composition is synthesized, processed and used. In some preferred ionomers, the cations used are metal cations, which may be monovalent, divalent, trivalent, multivalent, or mixtures thereof. Useful monovalent metal cations include but are not limited to cations of sodium, potassium, lithium, silver, mercury, copper, and the like, and mixtures thereof. Useful divalent metal cations include but are not limited to cations of beryllium, magnesium, calcium, strontium, barium, copper, cadmium, mercury, tin, lead, iron, cobalt, nickel, zinc, and the like, and mixtures thereof. Useful trivalent metal cations include but are not limited to cations of aluminum, scandium, iron, yttrium, and the like, and mixtures thereof. Useful multivalent metal cations include but are not limited to cations of titanium, zirconium, hafnium, vanadium, tantalum, tungsten, chromium, cerium, iron, and the like, and mixtures thereof. It is noted that when the metal cation is multivalent, complexing agents such as stearate, oleate, salicylate, and phenolate radicals may be included, as described in U.S. Patent No. 3,404,134. In another preferred composition, the metal cations used are monovalent or divalent metal cations. Preferred metal cations are sodium, lithium, magnesium, zinc, potassium and mixtures thereof. In yet another preferred composition, the cations of sodium, zinc and mixtures thereof are more preferred.

The resulting neutralized ionomer will have a melt index, as determined in accordance with ASTM method D1238-89 at 190°C and 2.16 kg, that is lower than that of the corresponding ethylene copolymer.

The acid copolymer composition also includes a hydroxyl-containing crosslinking agent. As used herein, the term "hydroxyl-containing crosslinking agent" refers to any molecule that is miscible with the ethylene copolymer and that has two or more hydroxyl groups. Generally, any hydroxyl-containing crosslinking agent can be contemplated for use with the present invention. Combinations of two or more hydroxyl-containing crosslinking agents may also be used. Examples of suitable hydroxyl-containing crosslinking agents include, without limitation, dihydroxyl, trihydroxyl and multihydroxyl compounds. Of note are glycols, such as propylene glycol; sorbitol; glycerol; poly(alkylene glycols), such as PEG600 and PEG2000; glycerol monstearate; and polyvinyl alcohol. Preferred are diols, such as 1,4-butanediol, 1,3-propanediol and 1,6-hexanediol. 1,4-Butanediol is particularly preferred.

The hydroxyl-containing crosslinking agent is included in the acid copolymer composition in an amount of up to about 5 wt%, preferably about 2 wt% or less or about 1.5 wt% or less, more preferably about 1 wt% or less, 0.5 wt% or less, or 0.25 wt% or less, or 0.1 wt%, based on total weight of the acid copolymer composition.

Those of skill in the art are able to determine an appropriate level of cross-linking based on the physical properties that are desired in the cross-linked composition. For example, higher levels of cross-linking are correlated with a higher flex modulus, better high temperature adhesion, lower melt indices, and better heat resistance. However, consideration should be made to adjust the level of cross-linking so that the desired end use performance is obtained. For example, a level of cross-linking may be desirable at which the creep or displacement properties are controlled or minimized at the expected stress level and temperature range for said article. A level chosen by these criteria allows for the ease of processing of the cross-linked resin, through extrusion and any other secondary or forming/shaping process.

Those of skill in the art are also aware that the time required to obtain a desired level of cross-linking depends directly on the concentration of carboxylic acid groups and hydroxyl-containing groups. Likewise, the time required to obtain a desired level of cross-linking can depend inversely on the temperature at which the cross-linking reaction is carried out, and also can depend inversely or in another negative logarithmic relationship on the melt index of the polymer blend.

Cross-linking reactions can require heat, but the reaction may also be carried out using catalysis, or by using a combination of heat and catalysis. For example, esterification reactions are known to be catalyzed by acid catalysts and by base catalysts.

While any hydroxyl-containing crosslinking agent compound can be used for the purposes described herein, 1,4-butanediol has been shown to have particularly good cross-linking capabilities. Generally, amounts of 5% by weight of 1,4-butanediol can be added, although preferably an amount of 2% or less, or more preferably an amount of 1.5% or less, or more preferably about 1 wt% or less, 0.5 wt% or less, or 0.25 wt% or less, or 0.1 wt% or less is used. All percentages are based on the total weight of the composition.

The hydroxyl-containing crosslinking agent can be added to the ionomer in any convenient manner. One particularly useful way is to add the agent to the ionomer flake in the pre-mix chamber of an extruder. Another way to introduce this agent is through an injection port. As these materials are mixed, generally by tumbling or dry-auger blending, before going into the extruder, the cross-linking agent is incorporated into the polymer composition and may react so that the cross-linking occurs in the ionomer as it is extruded. Alternatively, the cross-linking reaction can take place during melt mixing or extrusion of the melt.

The polymer composition described herein comprises one or more adjuvants. The term adjuvant as used herein refers to "additives that contribute to the effectiveness of the primary ingredient" (The Condensed Chemical Dictionary, 10th Ed., revised by Gessner G. Hawley, Van Nostrand Reinhold Co., New York, NY, 1981). Without wishing to be held to theory, it is believed that the adjuvants contribute to the effectiveness of the crosslinking agent(s), for example, by enhancing the kinetics of the acid or base catalysis. Suitable adjuvants include silanes. When silanes are used, they can be added in amounts of between 0.025 and 0.1 weight percent (wt%). Non-limiting examples of preferred silanes include N-(2-aminoethyl-3-aminopropyl) trimethoxysilane, 3-glycidoxypropyl trimethoxysilane, and combinations thereof. Preferably, the adjuvant comprises a silane selected from the group consisting of N-(2-aminoethyl-3-aminopropyl) trimethoxysilane, 3-glycidoxypropyl trimethoxysilane, and combinations thereof, in amounts of between about 0.025 and 2.0 wt%. Available from any convenient source, the silane adjuvants can be added to the base resin in weight percent amounts of 0.025, 0.25, 0.1, and 1.0, based on the total weight of the polymer composition.

The adjuvant can be added at the same time and in the same manner as the hydroxyl-containing crosslinking agent, or by any other known method. In the case of extrusion processing, the typical temperature range is generally between about 120°C and 300°C, depending on the melt point, melt viscosity and specific equipment configuration. The reaction will be dependent on the time and temperature parameters set forth and established through the entire series of process steps. The degree of reaction can be affected by the level of moisture within the resin, or any added moisture. In general, increased levels of moisture decrease the degree of reaction. Depending on the desired end result, this may be an undesirable effect. Alternatively, moisture can advantageously be used as a limiting means to reduce the extent of the cross-linking. Catalysts may also be included, such as the creation of either acid or base conditions to catalyze the cross-linking. Alternatively, a specific catalyst, such as dibutyl tin oxide or similar compound, could be employed.

The present invention also includes a product of the cross-linking the polymer composition as described above, so that at least a portion of the carboxylic acid groups of one or more ethylene copolymer molecules are reacted with at least two hydroxyl groups of the hydroxyl-containing crosslinking agent, thereby forming cross-links between or within the ethylene copolymer molecules. In one embodiment, at least a portion of the carboxylic acid groups of two or more ethylene copolymer molecules are reacted with at least two hydroxyl groups of the hydroxyl-containing crosslinking agent, thereby forming cross-links between the ethylene copolymer molecules.

Without wishing to be held to theory, it is hypothesized that during the extrusion process, the crosslinking agent and optionally, the adjuvant compound will react with the resin to form a low-density level of crosslinks in at least an intermolecular fashion. The crosslinking agent can react with carboxylic acid groups thus forming an ester-bond, and can additionally react via transesterification with existing or thus-formed ester-bonds. This reactivity can be controlled via selection of the crosslinking agent and specific resin composition containing reactive functional groups. One skilled in the art can utilize conventional understanding of relative reactivity and dependencies on adjacent chemical groups/atoms, steric hindrance, and other molecular/structural effects. Again without wishing to be held to theory, it is hypothesized that the adjuvant compound enhances the crosslink density by forming or by promoting the formation of ester-bonds. Additionally, the choice of other pendant functional groups within silane adjuvants may enable other reactions to occur. For example, amino-groups could form an amide bond and epoxy groups can react with hydroxyl groups to form additional hydroxyl side-groups. Alternatively, epoxy groups may initiate various other reactions via a free-radical pathway.

The resulting cross-linked polymer composition may have a MFR of 25 g/10 min or less, or about of 20 g/10 min or less, or about 10 g/10 min or less, or about 5 g/10 min or less, or about 0.7 to about 5 g/10 min, as determined in accordance with ASTM method D1238-89 at 190°C and 2.16 kg.

The polymer composition described herein may further contain other additives known within the art. The additives include, but are not limited to, processing aids, flow enhancing additives, lubricants, pigments, dyes, flame retardants, impact modifiers, nucleating agents, anti-blocking agents such as silica, thermal stabilizers, UV absorbers, UV stabilizers, dispersants, surfactants, chelating agents, coupling agents, reinforcement additives, such as glass fiber, fillers and the like. General information about suitable additives, suitable levels of the additives in the ionomeric polymers, and methods of incorporating the additives into the ionomeric polymers may be found in reference texts such as, for example, the Kirk Othmer Encyclopedia, the Modern Plastics Encyclopedia, McGraw-Hill (New York, 1995) or the Wiley Encyclopedia of Packaging Technology, 2d edition, A.L. Brody and K.S. Marsh, Eds., Wiley-Interscience (Hoboken, 1997). Four types of additives are of note for use in the ionomeric polymers, specifically thermal stabilizers, UV absorbers, hindered amine light stabilizers (HALS), and silane coupling agents. Further information about these four types of additives, such as preferred examples and suitable levels in ionomeric polymers, may be found in the reference texts cited above and in U.S. Patent No. 7,641,965, for example.

The present invention also includes the use of the aforementioned novel polymer compositions in end-uses including packaging films and sheets, and injection molded/thermoformed articles. Accordingly, provided herein are sheets and films comprising or made from the polymer composition. Further provided are sheets and films comprising or made from a product of crosslinking the polymer composition.

The difference between a film and a sheet is the thickness; however, there is no set industry standard as to when a film becomes a sheet. As used herein, the term "film" refers to a structure having a thickness of about 20 mils (0.50 mm) or less, and the term "sheet" refers to a structure having a thickness of greater than about 20 mils (0.50 mm). Nevertheless, when the polymer compositions are in sheet form, they can be of any useful thickness. For example, when used as packaging films, these polymer compositions can have a thickness between about 0.4 mil and about 20 mils (about 10 to about 500 micrometers), and preferably between about 0.9 and about 6 mils (about 25 to about 150 micrometers). The packaging films can comprise more than one layer.

Sheets comprising the polymer compositions may be formed by any suitable method, including without limitation dipcoating, solution casting, compression molding, injection molding, lamination, melt extrusion casting, blown film, extrusion coating, tandem extrusion coating, or by a combination of two or more of these methods. Preferably, the sheets are formed by an extrusion method, such as melt extrusion casting, melt coextrusion casting, melt extrusion coating, or tandem melt extrusion coating processes.

In another embodiment, the article is a film or sheet, which may be prepared by any convention process, such as, dipcoating, solution casting, lamination, melt extrusion, blown film, extrusion coating, tandem extrusion coating, or by any other procedures that are known to those of skill in the art. In certain embodiment, the films or sheets are formed by melt extrusion, melt coextrusion, melt extrusion coating, blown film process, or tandem melt extrusion coating process.

Alternatively, the article comprising the polymer composition disclosed herein is a molded article, which may be prepared by any conventional molding process, such as, compression molding, injection molding, extrusion molding, blow molding, injection blow molding, injection stretch blow molding, extrusion blow molding and the like. Articles may also be formed by combinations of two or more of these processes, such as for example when a core formed by compression molding is overmolded by injection molding.

Information about these fabrication methods may be found in reference texts such as, for example, the Kirk Othmer Encyclopedia, the Modern Plastics Encyclopedia, McGraw-Hill (New York, 1995) or the Wiley Encyclopedia of Packaging Technology, 2d edition, A.L. Brody and K.S. Marsh, Eds., Wiley-Interscience (Hoboken, 1997).

In one alternative, the article comprising the polymer composition disclosed herein is an injection molded article having a minimum thickness (i.e, the thickness at the smallest dimension of the article) of at least about 1 mm. Or, the injection molded article may have a thickness of about 1 mm to 100 mm, or 2 mm to 100 mm, or 3 to about 100 mm, or about 3 to about 50 mm, or about 5 to about 35 mm.

In yet another alternative, the article is an injection molded article in the form of a multi-layer structure (such as an over-molded article), wherein at least one layer of the multi-layer structure comprises or consists essentially of the ionomer composition disclosed above and that layer has a minimum thickness of at least about 1 mm. Preferably, the at least one layer of the multi-layer article has a thickness of about 1 to about 100 mm, or 2 mm to 100 mm, or 3 to about 100 mm, or about 3 to about 50 mm, or about 5 to about 35 mm.

In yet another alternative, the article is an injection molded article in the form of a sheet, a container (e.g., a bottle or a bowl), a cap or stopper (e.g. for a container), a tray, a medical device or instrument (e.g., an automated or portable defibrillator unit), a handle, a knob, a push button, a decorative article, a panel, a console box, or a footwear component (e.g., a heel counter, a toe puff, or a sole).

In yet another alternative, the article is an injection molded intermediate article for use in further shaping processes. For example, the article may be a pre-form or a parison suitable for use in a blow molding process to form a container (e.g., a cosmetic container). The injection molded intermediate article may be in the form of a multi-layer structure such as the one described above, and it may therefore produce a container having a multi-layer wall structure.

In yet another alternative the article is an injection molded article in the form of a golf ball or a sub-part of a golf ball, for example a core or a mantle of a golf ball.

Injection molding is a well-known molding process. When the article disclosed herein is in the form of an injection molded article, it may be produced by any suitable injection molding process. Suitable injection molding processes include, for example, co-injection molding and over-molding (also referred to as two-shot or multi-shot molding processes).

When the injection molded article is produced by an over-molding process, the polymer composition may be used as the substrate material, the over-mold material or both. In certain articles, when an over-molding process is used, the polymer composition disclosed herein may be over-molded on a glass or metal container. Or the polymer compositions may be over-molded on any other articles (such as house items, medical devices or instruments, electronic devices, automobile parts, architectural structures, sporting goods, and etc.) to form a soft touch and/or protective overcoating. When the over-mold material comprises the polymer composition described herein, the melt index of the polymer composition is preferably from 0.75 up to about 25 g/10 min, as determined in accordance with ASTM D1238 at 190°C and 2.16 kg.

In fabrication processes that incorporate a form of blow molding, such as, for example, injection blow molding, injection stretch blow molding and extrusion blow molding, the polymer composition preferably comprises an ionomer having zinc cations. Also preferably, the precursor acid copolymer preferably has a melt index of about 10 to about 100 g/10 min, or about 10 to 70 g/10 min, as determined in accordance with ASTM D1238 at 190°C and 2.16 kg. In addition, the zinc ionomer preferably has a melt index of from about 0.1 to about 2.0 g/10 min, as determined in accordance with ASTM D1238 at 190°C and 2.16 kg.

The polymer composition may be molded at a melt temperature of about 120°C to about 250°C, or about 130°C to about 210°C. In general, slow to moderate fill rates with pressures of about 69 to about 110 MPa may be used. The mold temperatures may be in the range of about 5°C to about 50°C. Based on the polymer composition and the process type that is to be used, one skilled in the art would be able to determine the proper molding conditions required to produce a particular type of article.

One preferred injection molded article is a golf ball. For example, without limitation, injection molding conditions may include temperatures, pressures and cycle times as indicated in Table A.

**Table A**

| | Temperature (°C) | Injection Pressure (mPa) | Cycle Times (sec) |
|---|---|---|---|
| Melt | 160-260 | Packing 25-180 | Filling and Packing 40-90 |
| Mold Front/Back | 10-30 | Hold 5-15 | Hold 15-30 |
| | | | Cooling Time 50-100 |
| | | | Screw Retraction 5-50 |

The compositions described herein may be used with any type of ball construction. It may be used in the core, cover, or one or more intermediate layers of a golf ball. Suitable golf ball constructions, including one-piece golf balls, two-piece golf balls, three-piece golf balls and multi-piece golf balls, are described in U.S. Pat. No.8,044,136, filed on October 30, 2008, as well as U.S. Pat. No. 8,202,925, and in the references cited therein, both issued to de Garavilla.

The following examples are provided to describe the invention in further detail. These examples, which set forth a preferred mode presently contemplated for carrying out the invention, are intended to illustrate and not to limit the invention.

### EXAMPLES

### Materials and Methods

"Resin A" was an ionomer of an ethylene acid copolymer comprising copolymerized repeat units of ethylene and about 21.7 wt% of copolymerized repeat units of methacrylic acid. Resin A was neutralized to a level of about 26% with a base having sodium cations as counterions. The melt index of the Resin A base resin was about 24 g/10 min, and that of Resin A was about 1.8 g/10 min.The polymers and additives were blended and extruded using a 28-mm twin-screw compounding extruder manufactured by Werner-Pfleiderer Corp. of Tamm, Germany. The extruded was equipped with a 6-mm single hole die and the melt strand was passed through a water bath for cooling and then cut into pellets using a Conair cutter.

1,4-Butanediol was obtained from the Aldrich Chemical Company, Inc., (Cat. No. B8, 480-7, 99% purity) and added to the base resin in amounts of 1.0, 1.5 and 2.0 wt%. When the adjuvants were used, they were added in amounts of between 0.025 and 0.1 wt%. The examples included below used N-(2-aminoethyl-3-aminopropyl) trimethoxysilane, 3-glycidoxypropyl trimethoxysilane, and combinations thereof, and were added to the base resin in amounts of 0.025, 0.25 and 0.1 wt%. The formed strand-cut pellets containing the blended polymer, hydroxyl-containing crosslinking agent, and optionally adjuvant, were dried and compression molded into plaques. Specimens were then punched out of the plaques and used for conducting tensile measurements.

These bars were index marked, weight added (where noted), then loaded and placed into an oven. Periodically, the oven was cooled, samples were removed and the "permanent" amount of elongation was measured. The samples were then placed back into the oven for additional exposure time, and the temperature was increased as noted.

### Examples

### Comparative Example A and Example 1

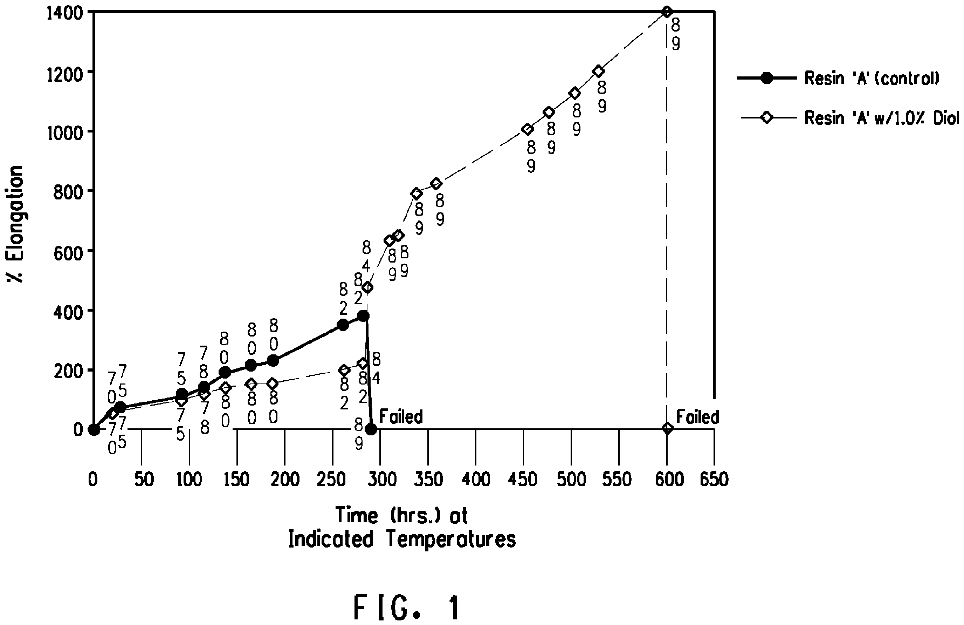

As described above, polymers were obtained, prepared and extruded to produce test specimens in the form of tensile strips. The tensile creep was measured according to ASTM D2990-09. The strips were then hung in an oven with a weight (82g) attached to the bottom. As shown in Table 1 and Figure 1, the tensile strip of Comparative Example A, achieved an elongation of less than 400% before mechanical integrity was lost. The strip of Example 1 continued to elongate to at least 1400% over a period of greater than 500 hours, without a loss of mechanical integrity.

**Table 1**

| | **Time, hr** | **0** | **16** | **24** | **92** | **116** | **140** | **164** | **188** | **262** | **284** | **287** | **290** | **307** | **315** | **334** |
|---|---|---|---|---|---|---|---|---|---|---|---|---|---|---|---|---|
| | **Temp, deg C** | **23** | **70** | **75** | **75** | **78** | **80** | **80** | **80** | **82** | **82** | **84** | **89** | **89** | **89** | **89** |
| | | | | | | | | | | | | | | | | |
| **EXAMPLE RESIN 'A' with 1.0 wt% 1,4-butanediol** | | | | | | | | | | | | | | | | |
| Elongation in mm | | | | | | | | | | | | | | | | |
| Sample 1 | | 5.0 | 7.0 | 8.0 | 8.0 | 9.0 | 11.0 | 11.0 | 11.5 | 14.5 | 14.5 | 14.5 | 26.0 | 33.0 | 35.0 | 41.0 |
| Sample 2 | | 5.0 | 7.5 | 8.5 | 9.5 | 10.5 | 12.0 | 12.5 | 12.5 | 15.0 | 15.5 | 16.0 | 29.0 | 37.0 | 38.0 | 44.0 |
| Sample 3 | | 5.0 | 8.0 | 8.0 | 9.0 | 10.5 | 12.0 | 12.5 | 12.5 | 15.0 | 16.0 | 16.0 | 29.5 | 38.0 | 39.0 | 45.0 |
| Sample 4 | | 5.0 | 7.0 | 8.0 | 9,0 | 9.5 | 11.0 | 11.5 | 12.5 | 15.0 | 15.0 | 15.0 | 29.0 | 37.5 | 39.0 | 430 |
| | | | | | | | | | | | | | | | | |
| Distance | | 10.0 | 15.5 | 16.5 | 18.5 | 21.0 | 24.0 | 25.0 | 25.0 | 30.0 | 31.5 | 32.0 | 58.5 | 75.0 | 77.0 | 89.0 |
| Percent Elongation | | 0.0 | 55.0 | 65.0 | 85.0 | 110.0 | 140.0 | 150.0 | 150.0 | 200.0 | 215.0 | 220.0 | 485.0 | 650.0 | 670.0 | 790.0 |
| | | | | | | | | | | | | | | | | |
| | | | | | | | | | | | | | | | | |
| **COMPARATIVE EXAMPLE RESIN 'A" (control)** | | | | | | | | | | | | | | | | |
| Elongation in mm | | | | | | | | | | | | | Broke | | | |
| Sample CA1 | | 5.0 | 7.0 | 8.0 | 9.0 | 11.0 | 14.0 | 14.5 | 15.0 | 20.5 | 21.0 | 21.0 | | | | |
| Sample CA2 | | 5.0 | 8.0 | 9.0 | 10.0 | 12.0 | 14.5 | 16.0 | 16.5 | 22.5 | 24.5 | 24.5 | | | | |
| Sample CA3 | | 5.0 | 7.0 | 8.5 | 9.5 | 11.0 | 14.0 | 15.0 | 15.5 | 21.0 | 23.0 | 23.0 | | | | |
| Sample CA4 | | 5.0 | 7.0 | 8.0 | 9.0 | 10.0 | 13.0 | 14.0 | 14.5 | 20.0 | 21.0 | 21.0 | | | | |
| | | | | | | | | | | | | | | | | |
| Distance | | 10.0 | 15.0 | 17.5 | 19.5 | 23.0 | 28.5 | 31.0 | 32.0 | 43.5 | 47.5 | 47.5 | 0.0 | | | |
| Percent Elongation | | 0.0 | 50.0 | 75.0 | 95.0 | 130.0 | 185.0 | 210.0 | 220.0 | 335.0 | 375.0 | 375.0 | 5.0 | | | |

### Comparative Example B and Examples 2-7

As described above, additives were added to Resin A (Comparative Example B) in the weight percent amounts indicated below in Table 2, and dogbone plaques were formed. These plaques were die-cut using a punch and conformed to ASTM D638-10, Type V.

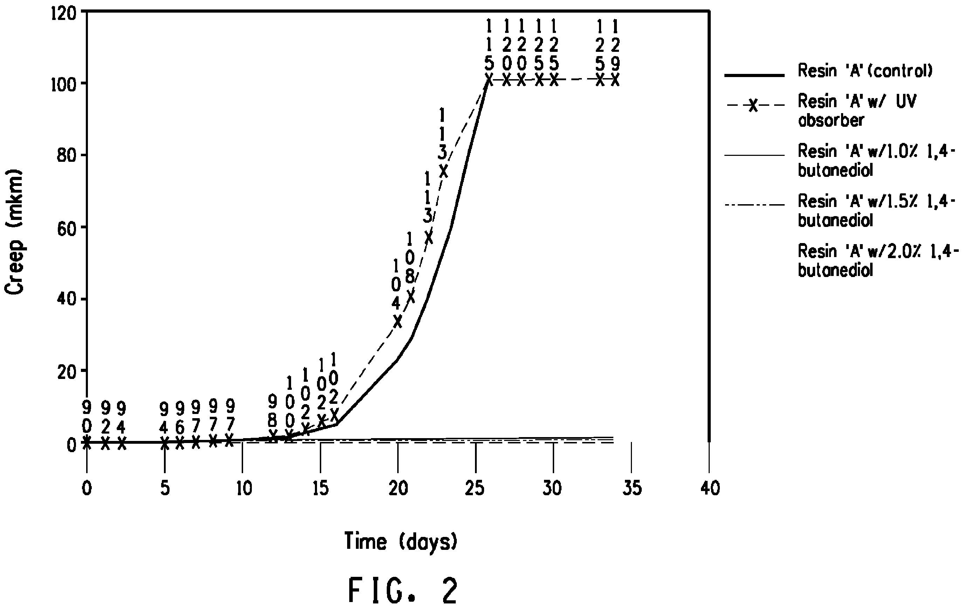

The tensile creep was measured according to ASTM D2990-09. Two indelible marks 10mm apart were put onto each plaque. The plaques were then suspended in an oven at the temperatures indicated in Table 3, below, and heated for the times indicated. No weight was applied to the bottom of the plaques. Table 3 shows the amount of elongation measured for each sample. These data show that the addition of 1,4-butanediol, N-(2-aminoethyl-3-aminopropyl) trimethoxysilane, and 3-glycidoxypropyl trimethoxysilane positively enhanced the tensile creep properties of the control Resin A (C.E. B). This is also shown in Figure 2.

**Table 2**

| | **Resin Additives Compounded into Resin, weight percent** | | |
|---|---|---|---|
| **Resin Identification** | **1,4-Butanediol** | **N-(2-aminoethyl-3-aminopropyl) trimethoxysilane** | **3-Glycidoxypropyl trimethoxysilane** |
| **Resin 'A', Comp. Ex. B** | 0 | 0 | 0 |
| **Resin 'B'** | 1 | 0 | 0 |
| **Resin 'C** | 0 | 0.025 | 0.025 |
| **Resin 'D'** | 1 | 0.025 | 0.025 |
| **Resin 'E'** | 0.05 | 0 | 0.1 |
| **Resin 'F'** | 0.05 | 0 | 0.25 |
| **Resin 'G'** | 0.1 | 0 | 0.25 |
| **Resin 'H'** | 0.25 | 0 | 0 |

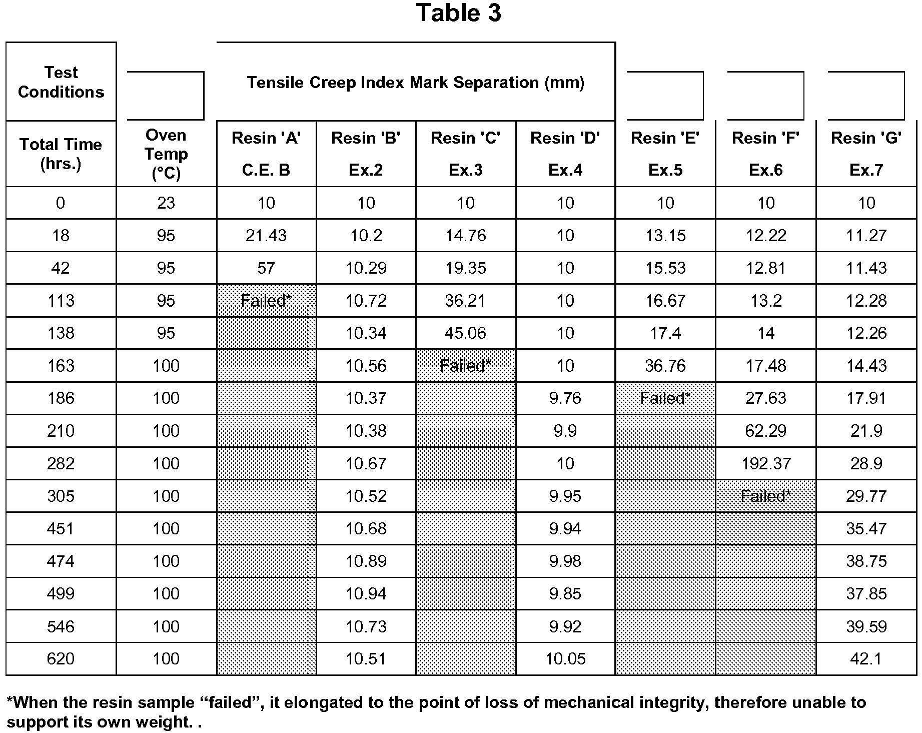

### Comparative Example C and Example 8

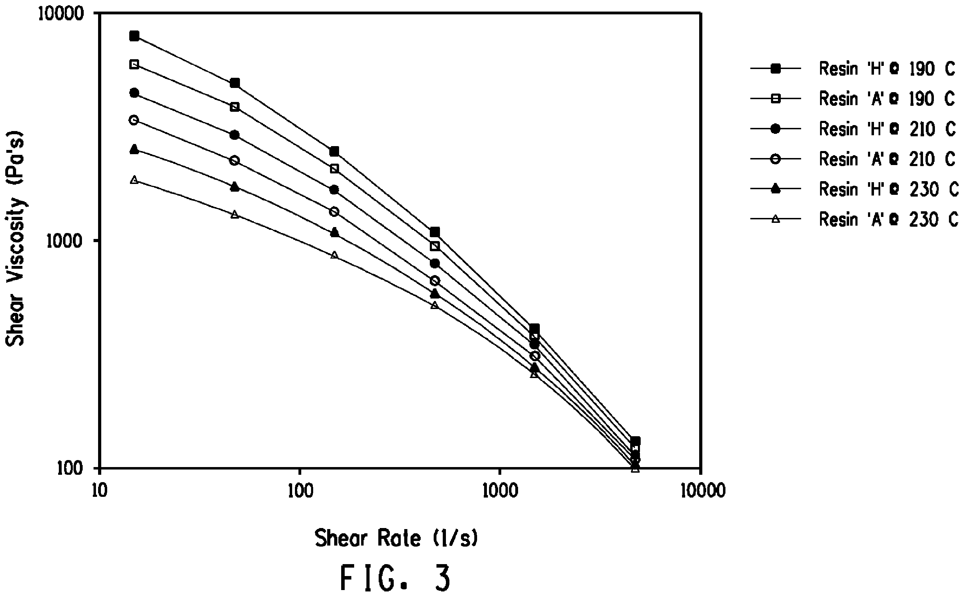

The rheology of both the control Resin A (Comparative Example C) and Resin H (Example 8, Resin A + 0.25 wt% 1,4-butanediol) were measured. An Bohlin Instruments RH7 Advanced Capillary Rheometer, available from Bohlin Instruments of East Brunswick, NJ, was used to measure melt viscosity at 190°C, 210 °C, and 230°C and at various shear rates as shown in Figure 3. The data show that there was only a modest change (increase) in melt viscosity at these shear rates and temperatures. Therefore, cross-linked compositions are expected to be readily and easily processible by conventional melt processing methods (e.g., extrusion, blown-film, injection molding, etc.).

Additionally, die swell was measured for both Comparative Example C and Example 8. The measurement represents how much larger in diameter a strand swells as it came out of the rheometer at a given shear stress/flow rate/temperature. Comparative Example C had a die swell of 41%, and Example 8 had a die swell of 73%, which was an indication that the molecular weight distribution has been broadened and most likely some higher molecular weight material had been created in the latter.

As shown in Table 4, melt draw and tension were measured for both Comparative Example C and Example 8 on a Bohlin Instruments RH7 Advanced Capillary Rheometer at 190°C and a crosshead speed of 2.26 mm/min. The haul-off die had a diameter of 2mm, a length of 20 mm, and a 180 degree (flat) entry angle. The following data shows the maximum haul-off speed (M/min) and haul-off force (N) at maximum haul-off speed for Comparative Example C and Example 8:

**Table 4**

| Resin | Max Haul-off Speed (M/min) | Haul-off Force (N) |
|---|---|---|
| Comp. Ex. C | 300 | 0.07 |
| Comp. Ex. C | 281 | 0.07 |
| Comp. Ex. C | 247 | 0.06 |
| Comp. Ex. C | 179 | 0.07 |
| Comp. Ex. C | 243 | 0.07 |
| Comp. Ex. C | 243 | 0.07 |
| Comp. Ex. C | 281 | 0.06 |
| Comp. Ex. C | 242 | 0.06 |
| Comp. Ex. C | 282 | 0.06 |
| Comp. Ex. C | 282 | 0.06 |
| **Average** | **258** | **0.065** |
| | | |

| Resin | Max Haul-off Speed (M/min) | Haul-off Force (N) |
|---|---|---|
| Example 8 | < 25 | 0.16 |
| Example 8 | < 25 | 0.24 |
| Example 8 | < 25 | 0.23 |
| Example 8 | < 25 | 0.22 |
| Example 8 | < 25 | 0.17 |
| Example 8 | < 25 | 0.24 |
| Example 8 | < 25 | 0.31 |
| Example 8 | < 25 | 0.30 |
| **Average** | **< 25** | **0.234** |

As can be seen in the data above, the melt tension for Example 8 was much higher than that of the Comparative Example C, although the maximum haul-off speed was reduced. Additionally, the melt tension at 10-25 meters/min for Comparative Example C was about 0.06 Newtons, and thus was fairly independent of draw speed. Also, the melt tension of Comparative Example C was much lower than the melt tension of Example 8, which was measured at 0.234 Newtons.

In summary, these Examples demonstrate that the cross-linking system described herein modifies the rheology, including the creep properties, of the acid copolymer resins and of their ionomers. The extrusion melt pressure and extruder torque necessary to process these compositions were not substantially affected by the crosslinking, however.

## Claims

1. A polymer composition comprising
an ethylene copolymer, said ethylene copolymer comprising copolymerized units of ethylene, 5 to 90 wt% of copolymerized units of a first α,β-unsaturated carboxylic acid having 3 to 10 carbon atoms; and optionally 2 to 40 wt% of copolymerized units of a derivative of a second α,β-unsaturated carboxylic acid having 3 to 10 carbon atoms; wherein the weight percentages of the copolymerized units are based on the total weight of the ethylene copolymer and the sum of the weight percentages of the copolymerized units is 100 wt%; and wherein optionally at least a portion of the carboxylic acid groups of the copolymerized units of the α,β-unsaturated carboxylic acid units are neutralized to form carboxylate salts; a hydroxyl-containing crosslinking agent; and
an adjuvant, wherein the adjuvant is a silane.

2. A product of cross-linking the polymer composition of Claim 1, wherein at least a portion of the carboxylic acid groups or carboxylate groups of two or more ethylene copolymers are reacted with at least two of the hydroxyl groups of the hydroxyl-containing crosslinking agent, so that the hydroxyl-containing crosslinking agent forms a cross-link between two or more ethylene copolymer molecules.

3. The polymer composition of Claim 1, wherein 1% to 90% of the total content of the carboxylic acid groups present in the ethylene copolymer have been neutralized to form carboxylate groups having counterions.

4. The polymer composition of Claim 1 or Claim 3, or the product of cross-linking of Claim 2, wherein the ethylene copolymer comprises 5 wt% to 30 wt% of copolymerized units of the first α,β-ethylenically unsaturated carboxylic acid, and 5 wt% to 30 wt% of copolymerized units of the derivative of the second α,β-unsaturated carboxylic acid.

5. The polymer composition of Claim 4, wherein the a,β-ethylenically unsaturated carboxylic acid is selected from the group consisting of acrylic acids, methacrylic acids, and mixtures of two or more of an acrylic acid and a methacrylic acid.

6. The polymer composition of Claim 1, wherein the hydroxyl-containing crosslinking agent comprises a diol.

7. The polymer composition of Claim 6, wherein the hydroxyl-containing crosslinking agent comprises 1,4-butanediol.

8. The polymer composition of Claim 1, wherein the adjuvant comprises a silane selected from the group consisting of N-(2-aminoethyl-3-aminopropyl) trimethoxysilane, 3-glycidoxypropyl trimethoxysilane, and combinations thereof, in amounts of between 0.025 and 2.0 wt%.

9. A film comprising the composition of Claim 1 or Claim 3, or the product of cross-linking of Claim 2.

10. An injection molded article comprising the composition of Claim 1 or Claim 3, or the product of cross-linking of Claim 2.

11. A golf ball comprising the composition of Claim 1 or Claim 3, or the product of cross-linking of Claim 2.

12. The polymer composition of Claim 1 or Claim 3, or the product of cross-linking of Claim 2, exhibiting an elongation of at least 10%, as determined by ASTM D2990-09.

13. The polymer composition of Claim 3, wherein the counter ion is sodium or zinc.

14. A package comprising the film of Claim 9.

## Patentansprüche

1. Polymerzusammensetzung umfassend
ein Ethylencopolymer, wobei das Ethylencopolymer copolymerisierte Einheiten von Ethylen, 5 bis 90 Gew.-% copolymerisierte Einheiten einer ersten α,β-ungesättigten Carbonsäure, die 3 bis 10 Kohlenstoffatome aufweist; und wahlweise 2 bis 40 Gew.-% copolymerisierte Einheiten eines Derivats einer zweiten α,β-ungesättigten Carbonsäure, die 3 bis 10 Kohlenstoffatome aufweist, umfasst; wobei die Gewichtsprozentsätze der copolymerisierten Einheiten auf das Gesamtgewicht des Ethylencopolymers bezogen sind und die Summe der Gewichtsprozentsätze der copolymerisierten Einheiten 100 Gew.-% beträgt; und wobei wahlweise mindestens ein Teil der Carbonsäuregruppen der copolymerisierten Einheiten der α,β-ungesättigten Carbonsäureeinheiten neutralisiert sind, um Carboxylatsalze zu bilden;
ein Hydroxyl enthaltendes Vernetzungsmittel; und
ein Hilfsmittel, wobei das Hilfsmittel ein Silan ist.

2. Produkt des Vernetzens der Polymerzusammensetzung nach Anspruch 1, wobei mindestens ein Teil der Carbonsäuregruppen oder Carboxylatgruppen von zwei oder mehr Ethylencopolymeren mit mindestens zwei der Hydroxylgruppen des Hydroxyl enthaltenden Vernetzungsmittels reagiert werden, so dass das Hydroxyl enthaltende Vernetzungsmittel eine Vernetzung zwischen zwei oder mehr Ethylencopolymermolekülen bildet.

3. Polymerzusammensetzung nach Anspruch 1, wobei 1 % bis 90 % des Gesamtgehalts der Carbonsäuregruppen, die in dem Ethylencopolymer vorliegen, neutralisiert worden sind, um Carboxylatgruppen zu bilden, die Gegenione aufweisen.

4. Polymerzusammensetzung nach Anspruch 1 oder Anspruch 3 oder Produkt des Vernetzens nach Anspruch 2, wobei das Ethylencopolymer 5 Gew.-% bis 30 Gew.-% copolymerisierte Einheiten der ersten α,β-ethylenisch ungesättigten Carbonsäure und 5 Gew.-% bis 30 Gew.-% copolymerisierte Einheiten des Derivats der zweiten α,β-ungesättigten Carbonsäure umfasst.

5. Polymerzusammensetzung nach Anspruch 4, wobei die α,β-ethylenisch ungesättigte Carbonsäure aus der Gruppe ausgewählt ist bestehend aus Acrylsäuren, Methacrylsäuren und Mischungen von zwei oder mehr einer Acrylsäure und einer Methacrylsäure.

6. Polymerzusammensetzung nach Anspruch 1, wobei das Hydroxyl enthaltende Vernetzungsmittel ein Diol umfasst.

7. Polymerzusammensetzung nach Anspruch 6, wobei das Hydroxyl enthaltende Vernetzungsmittel 1,4-Butandiol umfasst.

8. Polymerzusammensetzung nach Anspruch 1, wobei das Hilfsmittel ein Silan umfasst ausgewählt aus der Gruppe bestehend aus N-(2-Aminoethyl-3-aminopropyl)trimethoxysilan, 3-Glycidoxypropyltrimethoxysilan und Kombinationen davon in Mengen zwischen 0,025 und 2,0 Gew.-%.

9. Folie umfassend die Zusammensetzung nach Anspruch 1 oder Anspruch 3 oder Produkt des Vernetzens nach Anspruch 2.

10. Spritzgegossener Artikel umfassend die Zusammensetzung nach Anspruch 1 oder Anspruch 3 oder Produkt des Vernetzens nach Anspruch 2.

11. Golfball umfassend die Zusammensetzung nach Anspruch 1 oder Anspruch 3 oder Produkt des Vernetzens nach Anspruch 2.

12. Polymerzusammensetzung nach Anspruch 1 oder Anspruch 3 oder Produkt des Vernetzens nach Anspruch 2, das eine Dehnung von mindestens 10 %, wie durch ASTM D2990-09 bestimmt, aufweist.

13. Polymerzusammensetzung nach Anspruch 3, wobei das Gegenion Natrium oder Zink ist.

14. Verpackung umfassend die Folie nach Anspruch 9.

## Revendications

1. Composition polymère comprenant
un copolymère d'éthylène, ledit copolymère d'éthylène comprenant des motifs copolymérisés d'éthylène, de 5 à 90 % en pds de motifs copolymérisés d'un premier acide carboxylique α,β-insaturé possédant de 3 à 10 atomes de carbone; et éventuellement de 2 à 40 % en pds de motifs copolymérisés d'un dérivé d'un second acide carboxylique α,β-insaturé possédant de 3 à 10 atomes de carbone; les pourcentages en poids des motifs copolymérisés étant basés sur le poids total du copolymère d'éthylène et la somme des pourcentages en poids des motifs copolymérisés étant de 100 % en pds; et éventuellement au moins une partie des groupes acide carboxylique des motifs copolymérisés des motifs acide carboxylique α,β-insaturé est neutralisée pour former des sels carboxylates;
un agent de réticulation contenant un groupe hydroxyle; et
un adjuvant, l'adjuvant étant un silane.

2. Produit de réticulation de la composition polymère selon la revendication 1, au moins une partie des groupes acide carboxylique ou des groupes carboxylate de deux copolymères d'éthylène ou plus étant mise à réagir avec au moins deux des groupes hydroxyle de l'agent de réticulation contenant un groupe hydroxyle, de sorte que l'agent de réticulation contenant un groupe hydroxyle forme une réticulation entre deux molécules copolymère d'éthylène ou plus.

3. Composition polymère selon la revendication 1, de 1 % à 90 % de la teneur totale des groupes acide carboxylique présents dans le copolymère d'éthylène ayant été neutralisés pour former des groupes carboxylate possédant des contre-ions.

4. Composition polymère selon la revendication 1 ou la revendication 3, ou produit de la réticulation selon la revendication 2, le copolymère d'éthylène comprenant de 5 % en pds à 30 % en pds de motifs copolymérisés du premier acide carboxylique α,β-éthyléniquement insaturé, et de 5 % en pds à 30 % en pds de motifs copolymérisés du dérivé du second acide carboxylique α,β-insaturé.

5. Composition polymère selon la revendication 4, l'acide carboxylique α,β-éthyléniquement insaturé étant sélectionné dans le groupe constitué des acides acryliques, des acides méthacryliques, et des mélanges de deux ou plusieurs d'un acide acrylique et d'un acide méthacrylique.

6. Composition polymère selon la revendication 1, l'agent de réticulation contenant un groupe hydroxyle comprenant un diol.

7. Composition polymère selon la revendication 6, l'agent de réticulation contenant un groupe hydroxyle comprenant du 1,4-butanediol.

8. Composition polymère selon la revendication 1, l'adjuvant comprenant un silane sélectionné dans le groupe constitué du *N*-(2-aminoéthyl-3-aminopropyl)triméthoxysilane, du 3-glycidoxypropyl triméthoxysilane, et de leurs combinaisons, en quantités comprises entre 0,025 et 2,0 % en pds.

9. Film comprenant la composition selon la revendication 1 ou la revendication 3, ou produit de la réticulation selon la revendication 2.

10. Article moulé par injection comprenant la composition selon la revendication 1 ou la revendication 3, ou produit de la réticulation selon la revendication 2.

11. Balle de golf comprenant la composition selon la revendication 1 ou la revendication 3, ou le produit de la réticulation selon la revendication 2.

12. Composition polymère selon la revendication 1 ou la revendication 3, ou produit de la réticulation selon la revendication 2, faisant preuve d'un allongement d'au moins 10 %, tel que déterminé selon la norme ASTM D2990-09.

13. Composition polymère selon la revendication 3, le contre-ion étant le sodium ou le zinc.

14. Emballage comprenant le film selon la revendication 9.
